(19) Europäisches Patentamt
European Patent Office
Office européen des brevets

(11) **EP 4 273 626 A1**

(12) **EUROPEAN PATENT APPLICATION**

(43) Date of publication:
**08.11.2023 Bulletin 2023/45**

(21) Application number: **22171614.5**

(22) Date of filing: **04.05.2022**

(51) International Patent Classification (IPC):
**G03F 7/20** (2006.01)        **G01N 27/04** (2006.01)

(52) Cooperative Patent Classification (CPC):
**G03F 7/7085; G01N 27/04; G03F 7/70916**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
• **LIANG, Lei
5500 AH Veldhoven (NL)**

• **DE BRUIJCKERE, Joeri
5500 AH Veldhoven (NL)**
• **TORRETTI, Francesco
5500 AH Veldhoven (NL)**
• **DE MUNSHI, Debashis
5500 AH Veldhoven (NL)**

(74) Representative: **ASML Netherlands B.V.
Corporate Intellectual Property
P.O. Box 324
5500 AH Veldhoven (NL)**

(54) **DEVICE AND METHOD FOR MEASURING CONTAMINATION AND LITHOGRAPHIC APPARATUS PROVIDED WITH SAID DEVICE**

(57)    The disclosure provides a device and method for measuring contamination. The device comprises: a layer of a non-conducting material; a layer of a semi-metal arranged on the layer of the non-conducting material; at least one set of electrodes, each electrode being in electrical contact to the layer of the semi-metal; and an electrical source of a voltage or current connected to the at least two electrodes. The semi-metal may be graphene. The non-conducting material may be hexagonal boron nitride. The method includes measuring a change in resistivity of the layer of the semi-metal using a voltage and/or a current source connected to the at least two electrodes.

## Fig. 3

EP 4 273 626 A1

**Description**

FIELD

The present invention relates to a device and a method for measuring contamination. The invention also relates to a lithographic apparatus provided with said device. The contamination may be carbon based contamination. The contamination may be due to deposition of carbon based radicals in a lithographic apparatus.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Performance of EUV scanners suffers from carbon contamination. Contamination may cause drift in output or performance for, for instance, sensor and fiducial.

Carbon contamination is mostly caused by the carbonization of the photoresist volatile under exposure of EUV radiation. Currently, cleaning by hydrogen radical generation (HRG) is the way to remove the contamination. However, frequent cleaning and sensor matching (involving sensor and fiducial) are required. Both cost time as the lithographic apparatus and process need to be stopped. In a business where availability and machine uptime are very important for margins, reduced availability is a significant disadvantage.

SUMMARY

The present disclosure provides a device for measuring contamination, the device comprising:

-   a layer of a non-conducting material;
-   a layer of a semi-metal arranged on the layer of the non-conducting material;
-   at least one set of electrodes, each electrode being in electrical contact to the layer of the semi-metal; and
-   an electrical source of a voltage or current connected to the at least two electrodes.

In an embodiment, the device comprises at least two sets of electrodes in electrical contact to the layer of the semi-metal, an outer set of electrodes being connected to the electrical source, and an inner set of electrodes being connected to an electrical measurement device.

In an embodiment, the layer of the semi-metal comprises a layer of graphene.

In an embodiment, the layer of the non-conducting material comprises a layer of hexagonal boron nitride (hBN).

In an embodiment, the layer of non-conducting material and/or the layer of the semi-metal have a thickness not exceeding 3 nm. The layers of graphene and/or hBN may be mono-atomic layers.

According to another aspect, the disclosure provides a lithographic apparatus, comprising at least one device as described above.

In an embodiment, the lithographic apparatus comprises a sensor, at least one device as described above being arranged at or near the sensor.

In an embodiment, the lithographic apparatus comprises one or more mirrors for reflecting EUV radiation, at least one device as described above being arranged on at least one of the mirrors.

In an embodiment, the lithographic apparatus comprises a reticle and/or fiducial, at least one device as described above being arranged at or near the reticle and/or fiducial.

According to yet another aspect, the disclosure provides a method for measuring contamination, comprising the steps of:

-   depositing a layer of an electrically non-conducting material;
-   depositing a layer of a semi-metal arranged on the layer of the electrically non-conducting material;
-   arranging at least two electrodes in electrical contact to the layer of the semi-metal; and
-   measuring a change in resistivity of the layer of the semi-metal using a voltage and/or a current source connected to the at least two electrodes.

In an embodiment, wherein the step of measuring a change in resistivity comprises:

- providing at least two sets of electrodes in electrical contact to the layer of the semi-metal, an outer set of electrodes being connected to an electrical source , and an inner set of electrodes being connected to an electrical measurement device for measuring a current or voltage;
- providing a current or voltage using the electrical source;
- measuring the current or voltage over the inner set of electrodes using the electrical measurement device;
- calculating a change in resistivity based on the voltage or current; and
- estimating an amount of contamination based on the change in resistivity.

In an embodiment, the method comprises the steps of:

- irradiating a substrate covered with a layer of carbon containing resist with radiation;
- measuring an amount of the radiation using a sensor; and
- using the change in resistivity to accordingly adjust the measured amount of radiation.

In an embodiment, the radiation is extreme ultraviolet radiation (EUV).

BRIEF DESCRIPTION OF THE DRAWINGS

Embodiments of the invention will now be described, by way of example only, with reference to the accompanying schematic drawings, in which:

- Figure 1 depicts a lithographic system comprising a lithographic apparatus and a radiation source;
- Figure 2 shows a cross-sectional side view of a substrate and a sensor of the lithographic system;
- Figure 3 shows a cross-sectional side view of an area within the lithographic apparatus during use thereof, schematically indicating potential deposition of contaminants;
- Figure 4 depicts a diagram indicating filling of the electronic states in various types of materials at equilibrium; herein, height is energy while width is the density of available states for a certain energy in the material listed; the shade follows the Fermi-Dirac distribution (black: all states filled, white: no state filled);
- Figure 5 depicts a schematical top view of an embodiment of a device of the disclosure;
- Figure 6A depicts a schematical top view of an embodiment of a device of the disclosure;
- Figure 6B depicts a schematical top view of another embodiment of a device of the disclosure;
- Figure 7 depicts a schematical top view of yet another embodiment of a device of the disclosure;
- Figure 8 depicts a cross sectional side view of an embodiment of a device of the disclosure;
- Figure 9 shows a top view of an embodiment of the device of the disclosure during use thereof;
- Figure 10 schematically indicates resistivity of the device of the disclosure during use;
- Figures 11A to 11F show respective steps of an embodiment of a method to make a device of the present disclosure;
- Figure 12 shows a diagram indicating exemplary steps of a prediction method;
- Figure 13 shows a diagram indicating inputs and outputs of a prediction method; and
- Figure 14 shows a diagram of an estimated resistivity adjusted using a prediction method.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate.

The term "pellicle" may refer to a protective layer typically positioned in front of the reticle. For detail see, for instance, US patent number 10983431.

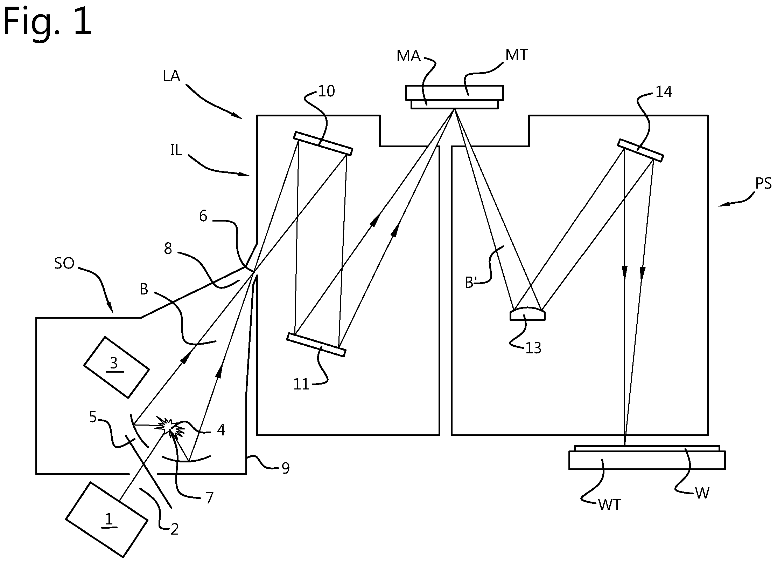

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a $CO_2$ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

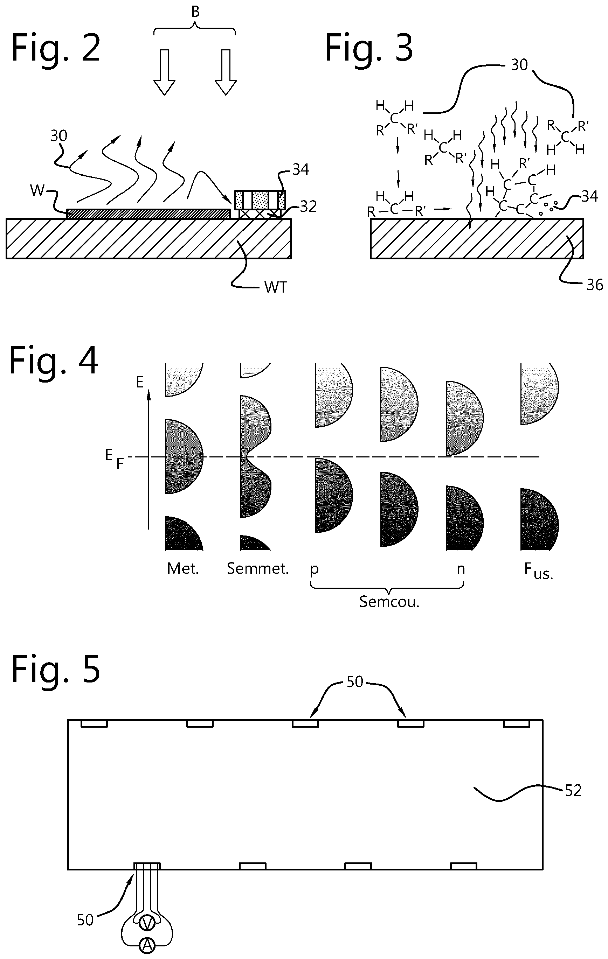

Generally referring to Figures 2 and 3, Performance of EUV scanner suffers from contamination, most notably carbon contamination. Contamination may cause drift in output of, for instance, a sensor and fiducial (a thin protective membrane typically positioned in front of the mask MA (for details, see for instance WO2016/079051). Examples of contamination are plasma induced carbonization, EUV induced carbonization, airborne contamination, absorbed organic molecules from photoresists, and anything that can block EUV from reaching to the sensor.

Carbon contamination is mostly caused by the carbonization of the photoresist volatile under EUV exposure. A photoresist (also known simply as a resist) is a light-sensitive material used in several processes, such as photolithography, to form a patterned coating on a surface. The process begins by coating a substrate with a light-sensitive material, typically an organic material. As described with reference to Fig. 1, a patterned mask MA is then applied to the surface to block light, so that only unmasked regions of the material will be exposed to radiation. A solvent, called a developer, is then applied to the surface. In the case of a positive photoresist, the photo-sensitive material is degraded by light and the developer will dissolve away the regions that were exposed to light, leaving behind a coating where the mask was placed. In the case of a negative photoresist, the photosensitive material is strengthened (either polymerized or cross-linked) by radiation, and the developer will dissolve away only the regions that were not exposed to light, leaving behind a coating in areas where the mask was not placed.

Examples of photoresist include, but are not limited to, methyl methacrylate monomers, Polymethyl methacrylate (PMMA), acrylate monomer, a mixture of diazonaphthoquinone (DNQ) and novolac resin (a phenol formaldehyde resin) commonly referred to as DNQ-Novolac photoresist, and epoxy-based polymer.

Referring to Fig. 2, the wafer W is provided with a layer of photoresist. Upon exposure with a beam B of radiation, exposed sections of the resist may turn into volatile components 30. As indicated in Figure 3, the components 30 may typically include a reactive part, i.e. the volatile components may be regarded as free radicals. The latter can deposit on any surface within the lithographic apparatus LA. The volatile components 30 may, for instance, deposit on a sensor 32. The components 30 may deposit on the sensor 32 or any surface 36 (Fig. 3), forming a patch or layer of deposit 34.

The sensor 32 is typically located near the wafer W to measure and calibrate the energy of radiation in the beam B. Due to its location relatively near the wafer, the sensor 32 is especially vulnerable to deposition of volatile components 30. However, the volatile components 30 may deposit on other surfaces 36 as well, including surfaces of mirrors 5, 10, 11, 13, 14, the mask MA and associated parts such as the reticle, or any part of the walls of the projection system PS and illumination system IL.

Figure 4 schematically shows the filling of electronic states in various types of materials at equilibrium. Materials indicated are metals (Met.), semi-metals (Semmet.), Semiconductors (Semcon., with a sub-division in p-type semiconductors ($p$), n-type semiconductors ($n$), and intrinsic semiconductors represented in between the n-type and p-type semiconductors), and Insulators (Ins.). In the diagram of Fig. 4, height indicates energy E (vertical axis) while width (horizontal axis) represents the density of available states for a certain energy in the material listed. The shade follows the Fermi-Dirac distribution (black: all states filled, white: no state filled). In metals and semimetals, the Fermi level $E_F$ lies inside at least one band, rendering the material electrically conductive. In insulators and semiconductors, the Fermi level is inside a band gap. Insulators can be considered as electrically nonconductive. In semiconductors, the bands are near enough to the Fermi level to be thermally populated with electrons or holes.

Electrical resistivity, represented by the Greek letter p (rho), is a measure of the resistance of a specific material of a given size, to the electrical current conduction that flows through it. It is also referred to as the specific electrical resistance or volume resistivity. The SI unit of electrical resistivity is expressed in ohm-metres ($\Omega$m). It is also found in units of ($\mu\Omega$cm). Insulators have high values of electrical resistivity, typically in the order of $10^8$ $\Omega$m or more, whereas (metal) conductors have very small resistivity values, typically in the order of $10^{-8}$ $\Omega$m or less.

A semimetal is a material with a very small overlap between the bottom of the conduction band and the top of the valence band. According to electronic band theory, solids can be classified as insulators, semiconductors, semimetals, or metals. In insulators and semiconductors the filled valence band is separated from an empty conduction band by a band gap. For insulators, the magnitude of the band gap is larger (e.g., > 4 eV) than that of a semiconductor (e.g., < 4 eV). Because of the slight overlap between the conduction and valence bands, semimetals have no band gap and a negligible density of states at the Fermi level. A metal, by contrast, has an appreciable density of states at the Fermi level because the conduction band is partially filled.

Unlike a regular metal, semimetals have charge carriers of both types (holes and electrons), so that one could also argue that they should be called 'double-metals' rather than semimetals. However, the charge carriers typically occur in much smaller numbers than in a real metal. In this respect they resemble degenerate semiconductors more closely. This explains why the electrical properties of semimetals are partway between those of metals and semiconductors.

As semimetals have fewer charge carriers than metals, they typically have lower electrical and thermal conductivities. They also have small effective masses for both holes and electrons because the overlap in energy is usually the result of the fact that both energy bands are broad. In addition they typically show high diamagnetic susceptibilities and high lattice dielectric constants.

Examples of semi-metallic elements are alkaline earth metals, arsenic, antimony, bismuth, $\alpha$-tin (gray tin), and graphite, an allotrope of carbon. Arsenic (As) and antimony (Sb) are also considered metalloids, but the terms semimetal and metalloid are not synonymous. Semimetals, in contrast to metalloids, can also be chemical compounds, such as mercury telluride (HgTe), and tin, bismuth, and graphite are typically not considered metalloids. Transient semimetal states have been reported at extreme conditions. It has been recently shown that some conductive polymers can behave as semimetals.

Another example of a material that can be classified as a semimetal is graphene. Graphene is an allotrope of carbon consisting of a single layer of atoms arranged in a two-dimensional honeycomb lattice nanostructure. The name is derived from "graphite" and the suffix -ene, reflecting the fact that the graphite allotrope of carbon contains numerous double bonds.

Each atom in a graphene sheet is connected to its three nearest neighbors by a $\sigma$-bond, and contributes one electron to a conduction band that extends over the whole sheet. This is the same type of bonding seen in carbon nanotubes and polycyclic aromatic hydrocarbons, and (partially) in fullerenes and glassy carbon. These conduction bands (see Figure 4) make graphene a semimetal with unusual electronic properties that are best described by theories for massless relativistic particles. Charge carriers in graphene show linear, rather than quadratic, dependence of energy on momentum, and field-effect transistors with graphene can be made that show bipolar conduction. Charge transport is ballistic over long distances; the material exhibits large quantum oscillations and large and nonlinear diamagnetism. Graphene conducts heat and electricity along its plane.

Graphene absorbs light of all visible wavelengths, which accounts for the black color of graphite. Yet a single graphene sheet is nearly transparent because of its extreme thinness. However, graphene is substantially transparent of radiation falling in the EUV wavelength band.

The IUPAC (International Union for Pure and Applied Chemistry) recommends use of the name "graphite" for the three-dimensional material, and "graphene" only when the reactions, structural relations or other properties of individual layers are discussed. A narrower definition, of "isolated or free-standing graphene" requires that the layer be sufficiently isolated from its environment, but would include layers suspended or transferred to, for instance, silicon dioxide or silicon carbide.

The present disclosure provides one or more devices 50 for measuring contamination. Referring to Figure 5, the device or devices 50 can be arranged on any surface 52 of interest within the lithographic apparatus LA. The surface 52 may include, for instance, a surface at or near the sensor 32. At may indicate arranged on the sensor. Near the sensor may indicate adjacent to the sensor 32, within a distance of, for instance, about 1 mm to about 10 cm. Alternatively, one or more devices 50 may be provided on any one of the mirrors for reflecting EUV radiation. With reference to Figure 1, said mirrors may include mirrors 5, 10, 11, 13 and 14. One or more devices 50 may be arranged at or near a reticle and/or fiducial.

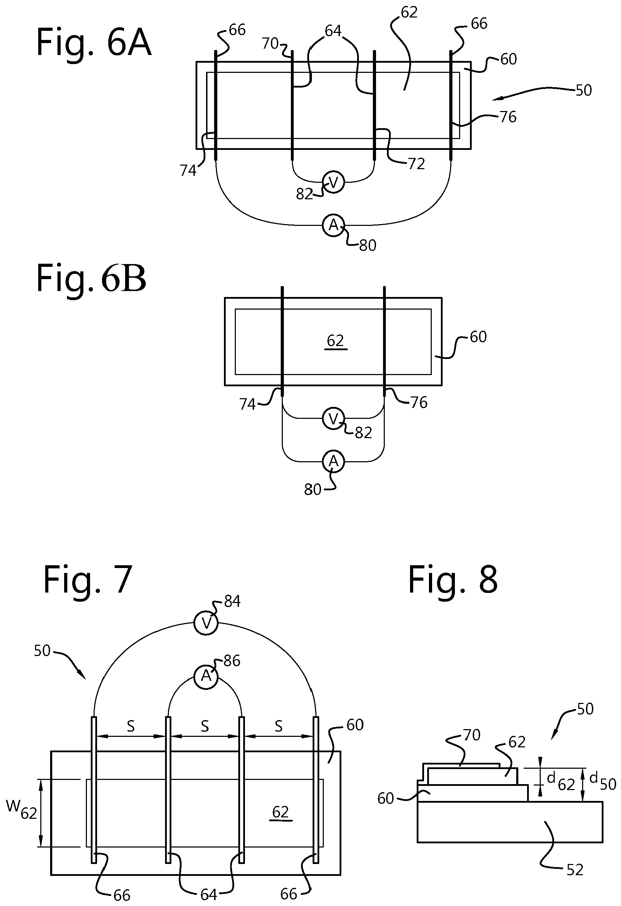

Referring to Figure 6A, the device 50 may comprise a first layer of a non-conducting material. A second layer 62 of a semi-metal can be arranged on the layer of the non-conducting material. The device 50 comprises at least one set of electrodes 64, 66, each electrode being in electrical contact to the layer of the semi-metal. For instance, the device may comprise a first set of electrodes 64, comprising first electrode 70 and second electrode 72. The device may comprise a second set of electrodes 66 comprising third electrode 74 and fourth electrode 76. The first and second electrodes may be arranged between the third electrode and fourth electrode. The first set 64 may be referred to as inner electrodes. The second set of electrodes 66 may be referred to as outer electrodes.

An electrical source of a voltage or current may be connected to the at least two electrodes of each set of electrodes. In an embodiment, a current source 80 may be connected to the outer electrodes 74, 76 of set 66. A voltage measurement device 82 may be connected to the set 66 of inner electrodes.

In another embodiment, see Figure 6B, a current source 80 may be connected to the electrodes 74, 76. A voltage measurement device 82 may be connected to the same electrodes.

Alternatively, see Figure 7, a voltage source 84 may be connected to the outer electrodes of set 66. A current measurement device 86 may be connected to the set 66 of inner electrodes.

As an alternative, the electrical source and electrical measurement device may be connected to the same set of electrodes. Alternatively ways of connecting may be possible as well. Aim is to measure changing resistivity of the device 50, as explained below.

In top view, as shown in Figures 6 and 7, the second layer 62 falls within the surface area of the non-conducting layer 60. Each electrode (exemplified by electrode 70 in Fig. 8) at least covers and/or makes electrical contact with the second layer 62. In side view, see Figure 8, the electrodes may make a step. The first layer 60 and second layer 62 in combination have a height H.

Thus, the device 50 may comprise at least two sets of electrodes in electrical contact to the layer 62 of the semi-metal. Herein, an outer set of electrodes 66 is connected to a source of current or voltage. An inner set of electrodes 64 is connected to an electrical measurement device of the opposite, i.e. a measurement of voltage or current respectively.

As a foundation of resistance measurement, Ohm's Law states that the ratio of potential difference V across the ends of a conductor of resistance R to the current I flowing in that conductor will be constant, provided that the temperature also remains constant. For most applications you can use a basic Ohm's Law equation of $I = V/R$ where I is the current through the conductor (given in amperes [A]), V is the potential difference measured across the conductor (given in volts [V]), and R is the resistance of the conductor (here R is a constant given in ohms [$\Omega$]). Vice versa, resistance R equals Voltage divided by Current ($R=V/I$). In this way, it is possible to derive any missing variable if the other two are known.

The resistance of the electrodes 70-76 between the device 50 and the respective electrical source 80 and electrical measurement device 82 may also need to be taken into consideration. Especially if the electrodes are relatively long. The electrodes may be made of, or may comprise, a metal having good conductivity. For example, the electrodes may be made of, or may comprise gold. Gold's electrical resistivity is about $2.44 * 10^{-8}$ $\Omega$ *m at 20 °C.

When measuring small resistances, as in the present disclosure, a technique may be to force a known current A, using the source 80, and then measure the voltage across the device 50 using the measurement device 82. This is in accordance with Ohm's Law since you're using the current and voltage to determine the resistance. The electrical source 80 may be, for instance, a precision current source of, for example, 2 milliamps or 200 microamps. The measurement device 82 may be a highly accurate voltmeter.

A four probe method, using four electrodes as shown in Figures 6A, 7 and 9, can be employed in order to remove the contact resistance of the graphene/electrodes. This is advantageous when the device 50 is in the form of a thin layer, such as a sheet of graphene. The layer 62 has a width $w_{62}$ and has a thickness $d_{62}$. A constant current can be passed through the two outer probes 74, 76. The potential drop V across the middle two probes 70, 72 can be measured.

At a constant temperature, the resistance, R of a conductor is proportional to its length L and inversely proportional to its area of cross section A. Herein, area A can be expressed as width W times thickness d of the sample:

$$R = \rho \frac{L}{Wd}\ (1)$$

Herein, r is the resistivity. Resistivity is a measure of the resistance of a given size of a specific material to electrical conduction. Resistivity may also be referred to as the specific electrical resistance, or volume resistivity. For the second layer 62, the width is $W_{62}$ and the thickness is $d_{62}$ (see Figures 7 and 8).

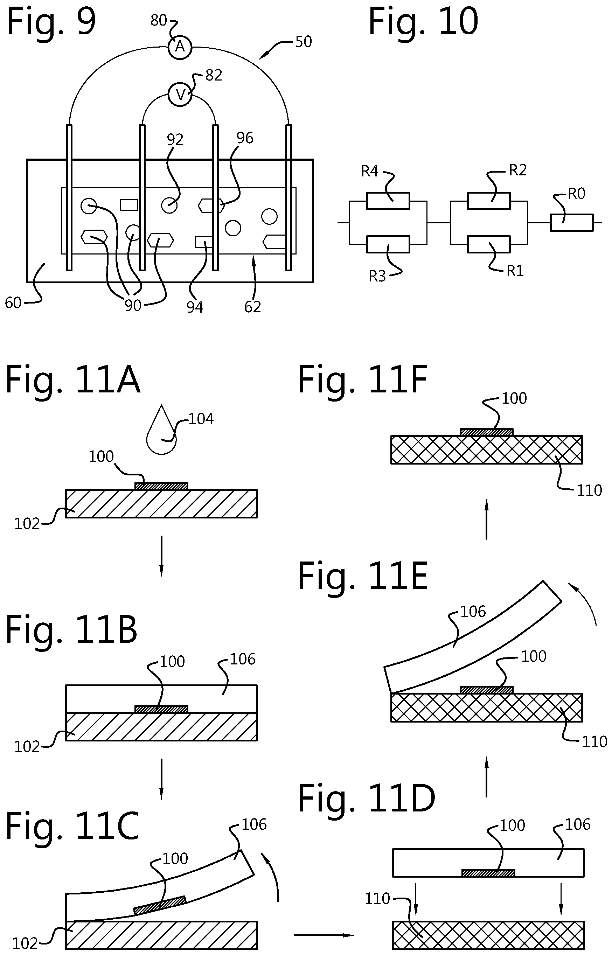

During use of the lithographic apparatus LA, contaminants may deposit on the device 50 over time. Figure 9 shows exemplary patches 90 of contaminant deposited on the second layer 62 of the device 50. Individual patches of contaminant 92, 94, 96 are labeled for explanatory purpose.

When contamination 90 comprising conductive elements such as carbon based components is partially deposited on top of graphene, the whole device will act as an equivalent circuit. See Figure 10. Herein, R0 is the resistance of graphene from uncontaminated areas. R1 and R3 indicate the resistance of sections of contaminated graphene. R2 and R4 indicate the resistance of the contamination 90 on respective sections of graphene. Before carbon contamination, the measured resistance is R0+R1+R3. When contamination deposits on top of the graphene, the measured resistance R between the inner electrodes can be expressed using formula (2):

$$R = R0 + \frac{R1R2}{R1+R2} + \frac{R3R4}{R3+R4}\ (2).$$

Because the resistivity (p) of carbon contamination is much smaller than the resistivity of the semi-metal, such as graphene, i.e. R2 << R1 and R4 << R1, formula (3) can be approximated by:

$$R = R0 + R2 + R4\ (3).$$

Thus, a change of resistivity R of the second layer 62 can be monitored as a resistance decrease from electrical measurement. Resistance of the carbon comprising contaminant can be determined by the shape, i.e. the length L, width W and thickness d, of the respective section or deposit of contamination, see patches 90. For example, the resistance R2 of a patch 92 of contamination (See Fig. 9 and 10) can be estimated using formula (4):

$$R2 = \rho \frac{L}{Wd}\ (4)$$

For the specific example of the patch of contamination relating to resistance R2, with increasing d, R2 decreases. As a result, the overall resistance R as measured using the electrodes 70 to 76 decreases.

The measured resistance R can be used to calculate or estimate the amound of contamination. This in turn enables to calibrate the output of the sensor 32 accordingly. With decreasing R, the scanner sensor reading will simultaneously decrease due to carbon contamination blocking incident radiation. Knowing the profile of change of the resistance R, the output of the scanner sensor 32 can be corrected. Thus, the contamination sensor 50 of the disclosure enables to reduces the necessity and frequency of, for instance, calibration of the sensor 32. As calibration of the sensor r costs scanner uptime, the device 50 enables to increase availability of the lithographic apparatus LA.

Resistivity of mono-layer graphene is relatively high ($R^2$ is about 1000 ohm). When amorphous carbon is formed on top of the graphene, it will act as a short circuit of the graphene channel. Therefore the measured resistivity will reduce.

Monitoring the resistivity of each graphene stack 50 will provide information relating to the rate of contamination and will allow to quantify the amount of the contamination.

The overall resistance R can be matched to a threshold. The threshold may be determined offline, for instance in laboratory tests. If the resistance R drops below said threshold, the level of contamination has exceeded a level requiring cleaning, for instance using hydrogen plasma as described above.

In a practical embodiment, the second layer 62 comprises or is entirely made of a semi-metal. In a preferred embodiment, the second layer comprises a layer of graphene.

The resistivity of monolayer graphene is high, which makes it sensitive to environment changes. It allows electrically measurement of carbon growth to be feasible. Graphene itself is conducting, which does not require the carbon contamination layer to be continuous.

In a practical embodiment, the first layer comprises a layer of hexagonal boron nitride (hBN), or is entirely made of hBN. Boron nitride is a thermally and chemically resistant refractory compound of boron and nitrogen with the chemical formula BN. It exists in various crystalline forms that are isoelectronic to a similarly structured carbon lattice. The hexagonal form corresponding to graphite is the most stable and soft among BN polymorphs. The partly ionic structure of BN layers in h-BN reduces covalency and electrical conductivity, whereas the interlayer interaction increases resulting in higher hardness of h-BN relative to graphite. The reduced electron-delocalization in hexagonal-BN is also indicated by its absence of color and a large band gap, in the order of 5 to 6.5 eV.

Graphene and the insulating substrate hBN can be very thin (mono-atomically thin, down to 1nm). Layers so thin will not change the reflectivity of the fiducial, mirrors or sensor diode transmittance. In effect, the mono-atomic layers, possible two, three, four or five layers, are transparent to EUV radiation. Graphene's carbon atoms are arranged into hexagons, forming a honeycomb-like lattice. Placing one or more layers of graphene on top of another leads to the formation of bilayer or multi-layer graphene. Graphene and hBN are very robust against EUV. Unlike EUV induced amorphous carbon, graphene will not be removed by flooding with EUV radiation.

In a practical embodiment, the layer of non-conducting material and/or the layer of the semi-metal have a thickness not exceeding 3 nm. In an embodiment, the first layer and/or the second layer have a thickness in the order of a single atomic layer. Optionally, the first layer and/or the second layer have a thickness in the order of two up to five atomic layers.

The above allow EUV to pass the first layer and second layer unobstructed. Both graphene and hBN absorb very little to no EUV. Also, both graphene and hBN can be deposited in single atomic layers, allowing both layers to be (extremely) thin and thus limit any EUV absorption to an absolute minimum. Graphene is one of only a few materials which are transparent for EUV .

Single-layer graphene can be synthesized using several methods. One method to synthesize high quality single-layer graphene is chemical vapor deposition (CVD). See, for instance, Synthesis of Single-layer Graphene: A Review of Recent Development by H. Cheun Lee et al., Procedia Chemistry, Volume 19, 2016, Pages 916-921.

Graphene layers can also be obtained by unzipping carbon nanotubes (CNTs) along the longitudinal direction. It has been reported that graphene can be synthesized by suspending multiwalled CNTs (MWCNTs) in sulfuric acid ($H_2SO_4$) for several hours, followed by potassium permanganate ($KMnO_4$) treatment at 70°C. This produces elongated strips of oxidized graphene nanoribbons. These nanoribbons can be further reduced by treating with an ammonium hydroxide ($NH_4OH$) and hydrazine monohydrate ($N_2H_4 \cdot H_2O$) solution. See, for instance, Structure and Chemistry of 2D Materials by Min-Ho Kang et al., in Comprehensive Nanoscience and Nanotechnology (Second Edition), 2019.

Figures 11A to 11F indicate steps how to transfer a layer of graphene 100 from a first substrate 100 to another, second substrate 110. The second substrate may be the layer of non-conducting material 60. The first substrate may be any suitable platform for making graphene layers, as exemplified in the articles referenced above. The first substrate may be a polymer film. The graphene layer may have been created in a clean-room environment.

In a first step, see Fig. 11A, a layer of graphene 100 may be create on a first substrate 102 using on the first substrate 102 is covered with a fluid 104. The fluid may be a suitable curable polymer.

In a second step, see Fig. 11B, the fluid 104 cures or hardens, creating a cured layer 106 covering the layer of graphene 110. The cured layer sticks to the graphene.

In a third step, the combination of the graphene and the cured polymer layer 106 is released from the first substrate 102. Releasing herein may involve adding a fluid such as water to disengage the graphene and/or the layer 106 from the substrate 102.

In a subsequent step, see Fig. 11D, the combination of the graphene 100 and the cured polymer layer 106 are moved to a location of choice on a second substrate 110. Said location is typically on the non-conducting layer 60 of the device 50.

Next, see Fig. 11E, the layer 106 is released from the graphene 100 and removed. Releasing and/or removing may involve, but is not limited to, adding a solvent or heating.

Finally, see Fig. 11F, the graphene 100 is at the selected location on the second substrate 110. The latter can form the second layer 62 of the device 50.

Similar steps as exemplified in Figures 11A to 11F can be applied to make and transfer one or more layers of hBN from one location to another. The latter can be applied to create the first, non-conducting layer 60 of the device 50.

During a lithographic process using the lithographic apparatus LA, carbon containing contaminants may build up on internal surfaces of the lithographic apparatus, as described with respect to Figures 2 and 3. The reading (output) of the sensor 32 may drift, i.e. diverge, as a result of the contamination. Thus, drift of the output of the wafer stage sensor 32 may be a result of contamination. The amount of contamination can be monitored by the contamination sensor 50 described above. Scanner sensor calibration costs time, and therefore negatively influences the availability (uptime) of the lithographic apparatus. With the introduction of the contamination sensor 50 of the present disclosure, the behavior of the scanner sensor 32 due to deposition of carbon containing contamination can be predicted based on the resistance change of the contamination sensor 50. With the in-situ monitoring of drift of the scanner sensor 32 by the invented contamination sensor 50, calibration time of the scanner sensor 32 can be significantly reduced, and the availability of the apparatus LA will increase accordingly.

Monitoring probing the resistivity of each graphene stack of each device 50 will provide information of the contamination rate and enables to quantify the amount of the contamination. When the contamination exceeds a certain threshold, the lithographic process can be stopped to clean the contamination (for instance using plasma cleaning).

During the lithographic process, a so-called sensor conversion factor (CF) can be used to translate light intensity as measured by the sensor 32 (with an output typically in a digital form, i.e. in bits) to a required dose of radiation (mJ/cm$^2$). Conventionally, the conversion factor is determined using an event referred to as sensor matching. Sensor matching requires the lithographic apparatus LA to shut down temporarily, to allow matching or calibrating the output of the sensor 32 to the dose of radiation provided. As a result, sensor matching decreases the availability or uptime of the lithographic machine LA. Minimizing the times of calibration therefore increases uptime and revenue.

The sensor 32 may comprise a slit and may be located at or near the wafer W. The sensor 32 may be frequently exposed to EUV radiation. Sensor contamination is mostly caused by the volatiles of the photoresist originating from exposure to EUV radiation. In order to make sure the conversion factor is within specified tolerances (for instance <0.5%), conventionally, operators of the apparatus LA may perform more frequent sensor matching, to ensure that the conversion factor used has not drifted from the real value more than the required maximum. Typically, with more contaminant on the sensor, the reading of the sensor 32 will be larger.

The sensor can be cleaned by hydrogen radical generation (HRG). However, this action decreases the availability of the lithographic apparatus LA.

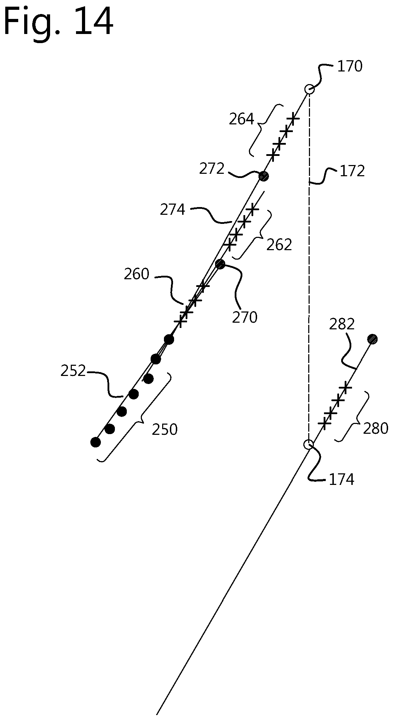

During the lithographic process, quantifying the amount of contamination using the one or more devices 50 enables to calibrate the reading of the sensor accordingly. For instance, the output of the sensor 32 may increase with increasing levels of contamination. Said relation may, for instance, be substantially linear. See Figure 14.

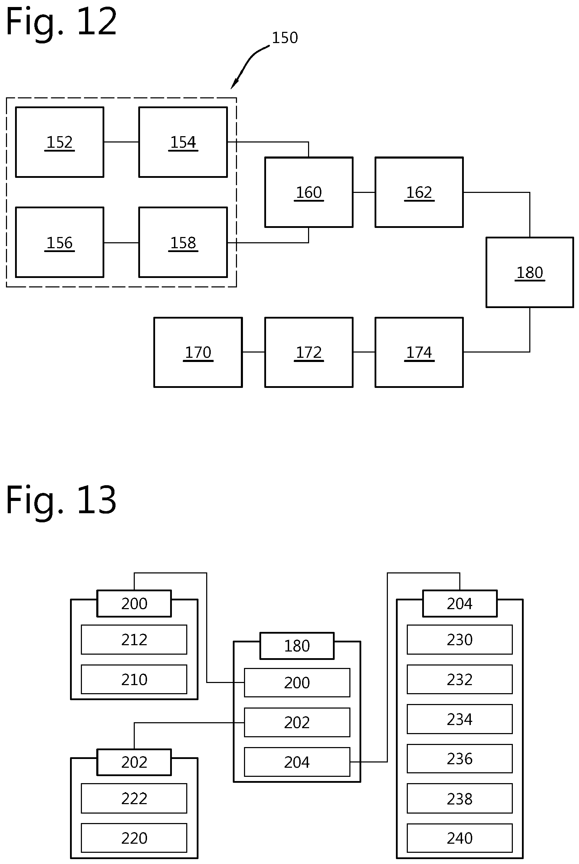

How to make a prediction is described below with reference to Figures 12 to 14. There can be two periods: A calibration period and a prediction period.

In the calibration period, there will be several discrete measurements of the scanner sensor 32. Meanwhile, the one or more contamination sensors 50 continue to measure the resistance change. Based on both measurements, two linear fittings can be drawn, which represent drift responses of the sensor due to contamination using the formulas:

$$slope1 = linear\ fitting(R_0, \ldots, R_n)$$

$$slope2 = linear\ fitting(S_0, S_1, S_2, S_n)$$

The two linear fittings likely yield different slopes. A correlation factor (CorrFactor) can be defined as:

$$CorrFactor = \frac{slope2}{slope1}$$

When the correlation has been thus determined, the frequency of calibrating the scanner sensor 32 can be significantly reduced. The value of the output of the scanner sensor 32 at any time t can be predicted by applying the fitting parameters in a way:

$$S_t = S_0 + CorrFactor * slope1 * t$$

Whenever values measured by the scanner sensor 32 (such as, for instance, focus, radiation dose, etc.) are requested, a predicted value will be provided. The predicted value 120 is the measured value including the drift correction. See Figure 14. If the contamination rate changes (for instance increases), this can be seen as a change of resistance of the contamination sensor (increased slope). The value of the output of the scanner sensor 32 at the same time t' can be predicted by applying the fitting parameters in a way:

$$S_t = (S_0 + CorrFactor * slope1 * t_c) + CorrFactor * slope3 * t'$$

where $t_c$ is the transition time of the slope. Over time, the prediction accuracy may decrease. The accuracy can be improved, for instance to the same level as before, by repeating the calibration.

Proposed is a feedforward method to predict the conversion factor CF at any time when requested with less frequent sensor matching input. The challenges to make an accurate prediction are:

- How to actively learn the trend change with new input and adjust the prediction accordingly?
- When there is a jump in the CF, how to correct it? The jump can be small or big, which may require a different response.

Figure 12 shows an exemplary flow chart of a potential cause of a jump in the conversion factor CF of the sensor 32. Figure 12 schematically indicates steps in a lithographic process. Herein, subset 150 of steps has characteristics of, or resembles, a chemical vapor deposition process.

The lithographic process includes a step of wafer cycling 152, i.e. exposing subsequent wafers to radiation in a lithographic process. The latter results in volatile organic compounds in the lithographic apparatus, indicated by step 154. The process 150 also includes a sensor matching step 156. During the process 150 however, the volatiles deposit on the inner surfaces of the apparatus LA, indicated by step 158.

A result of the deposition step 158 is a drift of the sensor reading, resulting in, typically, a drift rate or slope of the drift. The latter is indicated by step 160. In step 162, an estimation method may be used to estimate the sensor output. The estimation step 162 may use, for instance, linear regression.

A cleaning step 170 may involve hydrogen radical generation. After cleaning in step 170, the deposited contamination may have been substantially entirely removed, resulting in a step change or jump in the output of the sensor. The latter is indicated in step 172, indicating a jump in sensor output. Following step 172 is a step 174 of jump correction 174, i.e. a significant correction of the sensor reading incorporating the jump in output 172.

The result of the combination of cleaning 170 and relatively slow drift in output 160 is combined in a prediction step 180. The step 180 may be referred to as a feed forward prediction model.

Referring to Figure 13, the feedforward prediction model 180 may comprise an input 200, output 202, and an algorithm 204. The input 200 may comprise the conversion factor 210, and sensor usage count 212. The output may include an event log 220 and a scanner performance monitoring and analysis database 222. The algorithm may take into account information or input relating to training 230, detection of hydrogen radical generation 232, memory update 234, fitting 236, prediction 238, and/or verification 240.

Generally referring to Figure 14, at a high level the algorithm 204 works as follows:

- First collect a few inputs 250 as a training phase to make a linear fitting and obtain fit parameters (slope 252 and offset).
- Whenever the conversion factor CF is needed, such as for uniformity refreshment or for calibration, performance and/or diagnostics tests, the system makes a prediction 260, 262, 264 by taking into account the fit parameters and the predictor used. Inputs may include counter type inputs, such as an output of a slit energy counter.
- When there is a sensor matching event 270, 272 (which may still be done, but at a significantly reduced frequency compared to the conventional setup), the memory is actively updated to store data for fitting. A new fitting is made to change the fit parameters. The latter results in an adjusted slope 274 of the linear regression.
- When during the sensor matching there is a jump in measured conversion factor CF, this offset is corrected by removing the difference between the predicted conversion factor CF and the measured conversion factor CF.

At some point the sensor reading may exceed a predetermined threshold, prompting a cleaning step 170. The resulting jump or drop 172 in sensor reading results in an adjusted sensor reading 174. The adjusted sensor reading 174 may involve a sensor matching event.

The process continues based on the adjusted reading 174 with predicted sensor output values 180 based on slope 282 of a prediction model, such as linear regression.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A device comprising:

   - a layer of an electrically non-conducting material;
   - a layer of a semi-metal arranged on the layer of the electrically non-conducting material;
   - at least two electrodes, each electrode being in electrical contact to the layer of the semi-metal; and
   - an electrical source of a voltage or current connected to the at least two electrodes,
   wherein the device is for measuring contamination on top of the layer of the semi-metal using the electrical source.

2. The device of claim 1, comprising at least two sets of electrodes in electrical contact to the layer of the semi-metal, an outer set of electrodes being connected to the electrical source, and an inner set of electrodes being connected to an electrical measurement device.

3. The device of claim 1 or 2, wherein the layer of the semi-metal comprises a layer of graphene.

4. The device of one of the previous claims, wherein the layer of the electrically non-conducting material comprises a layer of hexagonal boron nitride (hBN).

5. The device of any of the previous claims, wherein the layer of electrically non-conducting material and/or the layer of the semi-metal have a thickness not exceeding 3 nm.

6. The device of any of the previous claims, wherein the contamination comprises carbon or/and wherein the contamination is from at least one of plasma induced carbonization, EUV induced carbonization, airborne contamination, organic molecules from photoresists.

7. A sensor assembly for measuring alignment of a wafer with respect to a mask, comprising the device according to any of claims 1-6.

8. A lithographic apparatus, comprising the device according to any of claims 1-6.

9. The lithographic apparatus of claim 8, comprising a sensor, the device according to any of claims 1-6 being arranged at or near the sensor.

10. The lithographic apparatus of claim 8 or 9, comprising a mirror for reflecting EUV radiation, the device according to any of claims 1-6 being arranged on or near the mirror.

11. The lithographic apparatus of one of claims 8 to 10, comprising a reticle and/or fiducial, the device according to any of claims 1-6 being arranged at or near the reticle and/or fiducial.

12. A method for measuring contamination, comprising the steps of:

   - depositing a layer of an electrically non-conducting material;
   - depositing a layer of a semi-metal arranged on the layer of the electrically non-conducting material;
   - arranging at least two electrodes in electrical contact to the layer of the semi-metal; and
   - measuring a change in resistivity of the layer of the semi-metal using a voltage and/or a current source connected to the at least two electrodes.

13. The method of claim 12, the step of measuring a change in resistivity comprising:

- providing at least two sets of electrodes in electrical contact to the layer of the semi-metal, an outer set of electrodes being connected to an electrical source , and an inner set of electrodes being connected to an electrical measurement device for measuring a current or voltage;
- providing a current or voltage using the electrical source;
- measuring the current or voltage over the inner set of electrodes using the electrical measurement device;
- calculating a change in resistivity based on the voltage or current; and
- estimating an amount of contamination based on the change in resistivity.

14. The method of claim 12 or 13, comprising the steps of:

- irradiating a substrate covered with a layer of carbon containing resist with radiation;
- measuring an amount of the radiation using a sensor; and
- using the change in resistivity to accordingly adjust the measured amount of radiation.

15. The method of claim 14, wherein the radiation is extreme ultraviolet radiation (EUV).

# Fig. 1

# Fig. 2

B

30

34

W

32

WT

# Fig. 3

30

H H
R—C—R'
H H
R—C—R'

H H
R—C—R'

H R'
H—C—C—H

H R'
R—C—R' →

H R'
H—C—C—C

34

36

# Fig. 4

E

$E_F$

Met.　Semmet.　p　　　　　　n　　$F_{us.}$

Semcou.

# Fig. 5

50

52

50

V

A

Fig. 6A

Fig. 6B

Fig. 7

Fig. 8

# Fig. 9

# Fig. 10

# Fig. 11A

# Fig. 11B

# Fig. 11C

# Fig. 11D

# Fig. 11E

# Fig. 11F

# Fig. 12

150

| | | | |
|---|---|---|---|
| 152 | 154 | 160 | 162 |
| 156 | 158 | | |

180

| | | |
|---|---|---|
| 170 | 172 | 174 |

# Fig. 13

200

212

210

202

222

220

180

200

202

204

204

230

232

234

236

238

240

# Fig. 14

Europäisches
Patentamt

European
Patent Office

Office européen
des brevets

# EUROPEAN SEARCH REPORT

Application Number

EP 22 17 1614

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 207 571 069 U (UNIV SHENZHEN) 3 July 2018 (2018-07-03) | 1,3,5,6, 12 | INV. G03F7/20 G01N27/04 |
| A | * the whole document * | 2,4, 7-11, 13-15 | |
| A | "Research Disclosure", RESEARCH DISCLOSURE, KENNETH MASON PUBLICATIONS, HAMPSHIRE, UK, GB, vol. 587, no. 8, 1 March 2013 (2013-03-01) , page 239, XP007141960, ISSN: 0374-4353 * the whole document * | 1-15 | |
| A | DE 10 2016 206210 A1 (ZEISS CARL SMT GMBH [DE]) 19 October 2017 (2017-10-19) * abstract * * figures 1-5 * * paragraphs [0001], [0011], [0022], [0039] * | 1-15 | |

TECHNICAL FIELDS
SEARCHED      (IPC)

G03F
G01N

The present search report has been drawn up for all claims

| Place of search | Date of completion of the search | Examiner |
|---|---|---|
| Munich | 26 October 2022 | Andersen, Ole |

CATEGORY OF CITED DOCUMENTS

X : particularly relevant if taken alone
Y : particularly relevant if combined with another
 document of the same category
A : technological background
O : non-written disclosure
P : intermediate document

T : theory or principle underlying the invention
E : earlier patent document, but published on, or
 after the filing date
D : document cited in the application
L : document cited for other reasons

.......................................................................................

& : member of the same patent family, corresponding
 document

EPO FORM 1503 03.82 (P04C01)

## ANNEX TO THE EUROPEAN SEARCH REPORT
## ON EUROPEAN PATENT APPLICATION NO.

EP 22 17 1614

This annex lists the patent family members relating to the patent documents cited in the above-mentioned European search report.
The members are as contained in the European Patent Office EDP file on
The European Patent Office is in no way liable for these particulars which are merely given for the purpose of information.

26-10-2022

| Patent document cited in search report | Publication date | Patent family member(s) | Publication date |
|---|---|---|---|
| CN 207571069 U | 03-07-2018 | NONE | |
| DE 102016206210 A1 | 19-10-2017 | DE 102016206210 A1 | 19-10-2017 |
| | | WO 2017178296 A1 | 19-10-2017 |

EPO FORM P0459

For more details about this annex : see Official Journal of the European Patent Office, No. 12/82

**REFERENCES CITED IN THE DESCRIPTION**

**Patent documents cited in the description**

- US 10983431 B

- WO 2016079051 A

**Non-patent literature cited in the description**

- **H. CHEUN LEE et al.** Synthesis of Single-layer Graphene: A Review of Recent Development. *Procedia Chemistry,* 2016, vol. 19, 916-921

- Structure and Chemistry of 2D Materials. **MIN-HO KANG et al.** Comprehensive Nanoscience and Nanotechnology. 2019